# EUROPEAN PATENT APPLICATION

(11) **EP 3 623 866 A1**
(43) Date of publication of application: **18.03.2020**
(21) Application number: 18912132.0
(22) Date of filing: 27.08.2018
(51) Int. Cl.: G03F 1/00, G09F 9/00

(54) **DISPLAY PANEL AND MASK PLATE USED FOR MANUFACTURING DISPLAY PANEL**

(30) Priority: 30.03.2018 CN 201820471716 U
(71) Applicant: Kunshan Go-Visionox Opto-Electronics Co., Ltd., Kunshan, Jiangsu 215300 (CN)
(72) Inventor: WANG, Xuliang, Kunshan, Jiangsu 215300 (CN); LIU, Mingxing, Kunshan, Jiangsu 215300 (CN); GAN, Shuaiyan, Kunshan, Jiangsu 215300 (CN); GAO, Feng, Kunshan, Jiangsu 215300 (CN)
(74) Representative: D'Halleweyn, Nele Veerle Trees Gertrudis
(86) International application number: PCT/CN2018/102547
(87) International publication number: WO 2019/184224

(57) **Abstract**

A display panel and a mask plate (500) used for manufacturing a display panel. The mask plate (500) is used to manufacture a display panel and comprises: a display zone (520), which is opened with a plurality of first through holes (521) provided at intervals; and a transition display zone (510), which is provided around the display zone (520) and which is opened with a plurality of second through holes (511) provided at intervals; the density of the second through holes (511) is less than the density of the first through holes (521). The display panel comprises a display substrate and pixels that are arranged in an array on the display substrate. The pixels are manufactured by means of the described mask plate (500). The mask plate (500) may increase the strength of a mask plate, thereby increasing the accuracy of pixel evaporation and preventing the problem of uneven color display at the edge of a display panel.

## Description

### TECHNOLOGY FIELD

The present application relates to the field of display technologies, and more particularly, to a display panel and a mask plate for fabrication thereof.

### BACKGROUND

With the development of display technology, the resolution of the display panel is becoming higher increasingly, and the resolution of the screen is greatly improved. As a result, the density of the pixel arrays becomes higher and higher, which presents a great challenge to the manufacturing process of a display panel. The pixel array is generally prepared by an evaporation process, for example, by accurately depositing a light-emitting layer onto a substrate through a fine metal mask plate to form a high-density pixel array. The number of openings of the mask plate is increasing, and the density of the openings is getting larger and larger, resulting in smaller and smaller distances between the openings and the strength of the mask plate is reduced.

In order to increase the strength of the mask plate, it is a traditional solution to change the shape or arrangement of the pixels in order to achieve the purpose of increasing an area of the connecting bridge, thereby improving the strength of the mask plate. However, by changing arrangement of the pixels to increase the strength of the mask plate, the results obtained are usually limited. Moreover, in many cases, it is difficult to increase the strength of the mask plate simply and effectively for the preparation of display panel of a conventional pixel arrangement type and in the case where the arrangement of the pixels cannot be adjusted.

### SUMMARY

Based on the above, the present application provides a display panel and a mask plate for fabricating the display panel, which can improve the strength of the edge of the mask plate, thereby improving the precision of pixel evaporation process and avoiding the problem of uneven color development at the edge of the display panel.

The present application provides a mask plate for making a display panel. The mask plate includes:
a display region, provided with a plurality of first through holes arranged at intervals; and
a transition display region, disposed at a periphery of the display region, and provided with a plurality of second through holes arranged at intervals;
a density of the second through holes is smaller than a density of the first through holes.

According to the mask plate described above, the density of the second through holes in the transition display region on the edge is changed, and the density of the second through holes in the transition display region is reduced. In this way, it is helpful to increase the distance between the second through holes, the area of the connecting bridge between the second through holes, and the strength of the edge region of the mask plate without affecting the display effect.

In one of the embodiments, a geometric center of each of the first through holes is a first hole center, and a geometric center of each of the second through holes is a second hole center;
the arrangement of the first hole centers in the display region is the same as the arrangement of the second hole centers in the transition display region; and
apertures of the second through holes are smaller than apertures of the first through holes.

In one of the embodiments, the first hole centers and the second hole centers are arranged in a row in a horizontal direction, and the first hole centers and the second hole centers are arranged in a column in a vertical direction;
distances between two adjacent first hole centers in the horizontal direction are equal, and distances between two adjacent first hole centers in the vertical direction are equal; and
distances between two adjacent second hole centers in the horizontal direction are equal, and distances between two adjacent first hole centers in the vertical direction are equal.

In one of the embodiments, a distance between the two adjacent first hole centers in the horizontal direction is equal to a distance between the two adjacent second hole centers in the horizontal direction; and a distance between the two adjacent first hole centers in the vertical direction is equal to a distance between the two adjacent second hole centers in the vertical direction.

In one of the embodiments, a row of the second through holes closest to the display region is a first row of through holes of the transition display region, with sequentially a second row to an N-th row of through holes of the transition display region provided along a direction away from the display region, and N being a positive integer;
a column of the second through holes closest to the display region is a first column of through holes of the transition display region, with sequentially a second column to an M-th column of through holes of the transition display region provided along a direction away from the display region, and M being a positive integer; and
apertures of the N-th row of through holes and the M-th column of through holes are at least 0.3 times of the apertures of the first through holes.

In one of the embodiments, apertures of the first row of through holes to the N-th row of through holes are reduced according to a first predetermined rule, and apertures of the first column of through holes to the M-th column of through holes are reduced according to a second predetermined rule.

In one of the embodiments, the number of rows and the number of columns of the second through holes are the same.

In one of the embodiments, when two rows and two columns of the second through holes are provided,
the apertures of the first row of through holes and the first column of through holes are 0.6-0.9 times of the apertures of the first through holes; and
the apertures of the second row of through holes and the second column of through holes are 0.3-0.6 times of the apertures of the first through holes.

In one of the embodiments, when three rows and three columns of the second through holes are provided,
the apertures of the first row of through holes and the first column of through holes are 0.7-0.9 times of the apertures of the first through holes;
the apertures of the second row of through holes and the second column of through holes are 0.5-0.7 times of the apertures of the first through holes; and
apertures of a third row of through holes and a third column of through holes are 0.3-0.5 times of the apertures of the first through holes.

In one of the embodiments, when four rows and four columns of the second through holes are provided,
the apertures of the first row of through holes and the first column of through holes are 0.8-0.9 times of the apertures of the first through holes;
the apertures of the second row of through holes and the second column of through holes are 0.6-0.8 times of the apertures of the first through holes.
apertures of a third row of through holes and a third column of through holes are 0.4-0.6 times of the apertures of the first through holes; and
apertures of a fourth row of through holes and a fourth column of through holes are 0.3-0.4 times of the apertures of the first through holes.

In one of the embodiments, when five rows and five columns of the second through holes are provided,
the apertures of the first row of through holes and the first column of through holes are 0.8-0.9 times of the apertures of the first through holes;
the apertures of the second row of through holes and the second column of through holes are 0.7-0.8 times of the apertures of the first through holes;
apertures of a third row of through holes and a third column of through holes are 0.6-0.7 times of the apertures of the first through holes;
apertures of a fourth row of through holes and a fourth column of through holes are 0.4-0.6 times of the apertures of the first through holes; and
apertures of a fifth row of through holes and a fifth column of through holes are 0.3-0.4 times of the apertures of the first through holes.

In one of the embodiments, the number of rows and the number of columns of the second through holes are different.

In one of the embodiments, when three rows and four columns of the second through holes are provided,
the apertures of the first row of through holes are 0.7-0.9 times of the apertures of the first through hole; the apertures of the second row of through holes are 0.5-0.7 times of the apertures of the first through holes; apertures of a third row of through holes are 0.3-0.5 times of the apertures of the first through holes; and
the apertures of the first column of through holes are 0.8-0.9 times of the apertures of the first through holes; the apertures of the second column of through holes are 0.6-0.8 times of the apertures of the first through holes; apertures of a third column of through holes are 0.4-0.6 times of the apertures of the first through holes; and apertures of a fourth column of through holes are 0.3-0.4 times of the apertures of the first through holes.

The present application also provides a display panel. The display panel includes:
a display substrate; and
pixels arranged in an array on the display substrate; and
the pixels are fabricated from the mask plate as described above.

### BRIEF DESCRIPTION OF THE DRAWINGS

To illustrate the technical solutions according to the embodiments of the present application or in the prior art more clearly, the accompanying drawings for describing the embodiments or the prior art are introduced briefly in the following. Apparently, the accompanying drawings in the following description are only some embodiments of the present application, and persons of ordinary skill in the art can derive other drawings from the accompanying drawings without creative efforts.
FIG. 1 is a schematic structural view of a fine metal mask plate according to a conventional solution.
FIG. 2 is a partial enlarged view of a display region opening and a transition display region opening of a fine metal mask plate according to a conventional solution.
FIG. 3 is a schematic structural view of a mask plate according to an embodiment of the present application.

### DETAILED DESCRIPTION OF THE EMBODIMENTS

In order to more clearly illustrate the embodiments of the present application or the technical solutions in the prior art, drawings used in the embodiments or the prior art description will be briefly introduced below. It is obvious that the drawings in the following description are only some of the embodiments of the present application, and those skilled in the art can obtain the drawings of other embodiments according to the above drawings without any creative work.

When fabricating the pixels on the display panel, each layer of the material of the pixels needs to be evaporated onto the array substrate by an evaporation process. In the evaporation process, a corresponding fine metal mask plate is required. Since a high temperature is generated during the evaporation process, the fine metal mask plate may occur a thermally expansion at this point, resulting in the fine metal mask plate being drooped under the effect of gravity, so that the geometry of the fine metal mask plate is changed, and the evaporation material cannot be evaporated to a specified position, which affects the evaporation precision, resulting in display unevenness and color mixing of the fabricated display panel.

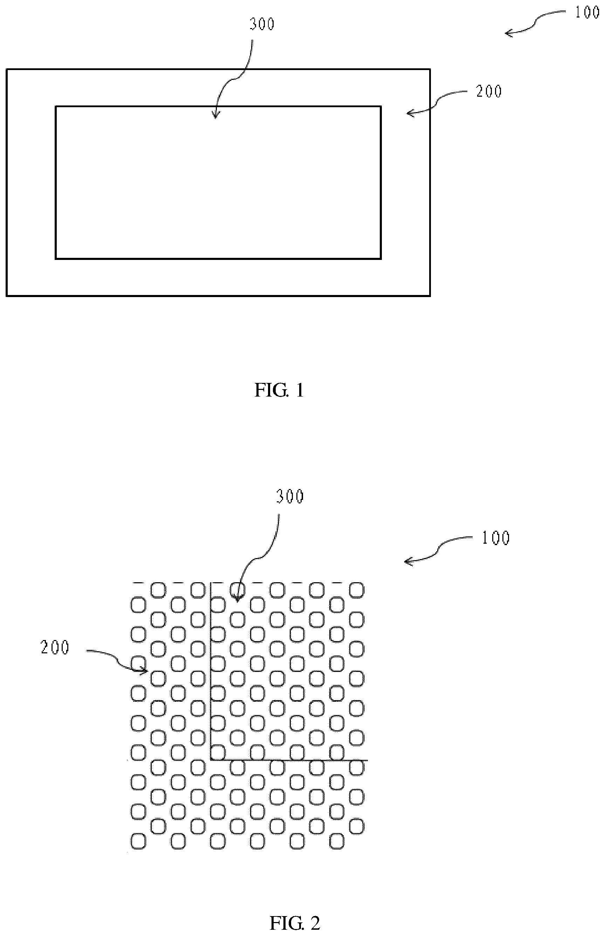

FIG. 1 is a schematic structural view of a fine metal mask plate according to a conventional solution. As shown in FIG. 1, the fine metal mask plate 100 is divided into a display region 300 and a transition display region 200. The display region 300 is a pixel evaporation region of the main display region of the display panel, and the transition display region 200 is a transition region of the display region 300 and the edge of the fine metal mask plate. The fine metal mask plate 100 is provided with openings arranged in an array for evaporating the evaporation material onto the array substrate. FIG. 2 is a partial enlarged view of a display region opening and a transition display region opening of a fine metal mask plate according to a conventional solution. As shown in FIG. 2, in the conventional solution, the openings of the display region 300 and the transition display region 200 are the same, that is, the shape of the opening, the size of the opening, and the density of the openings are the same.

In order to avoid the problem that the fine metal mask plate is easily deformed in the evaporation process, the fine metal mask plate is usually fixed to a metal frame, and then the fine metal mask plate with the metal frame is fixed on the array substrate to perform evaporation in the conventional solution. Specifically, when fixing the fine metal mask plate in the metal frame, it is necessary to choose an appropriate force firstly to stretch the fine metal mask plate, then an appropriate antagonistic force is applied to the metal frame to deform the metal frame, and finally, the stretched fine metal mask plate is fixed on the metal frame that the antagonistic force is applied. In this way, the fine metal mask plate is tensioned by the restoring force due to deformation of the metal frame, so that the fine metal mask plate will not be drooped during the evaporation process. This process of pre-tensioning the fine metal mask plate is generally referred to as a net-extending process.

Generally, in order to improve the precision of evaporation, it is necessary to perform a PPA (pixel position accuracy) test on the fine metal mask plate, so as to realize positioning of the fine metal mask plate and the array substrate in the conventional solution. Therefore, in the net-extending process, it is necessary to find an appropriate stretching force and an antagonistic force for deforming the metal frame, and to adjust the strength through a test for a real object so as to meet the precision requirement of the evaporation. However, since the opening of the fine metal mask plate are denser and denser, the distance between the openings, that is, the size of the connecting bridge between the openings, becomes smaller and smaller, the fine metal mask plate is easily damaged in the net-extending process, especially at the fixed edge. Due to the relatively concentrated force, the edge of the evaporation region is easily damaged, resulting in problems such as evaporation deviation and color mixing at the edge. Thus, the difficulty and cost of the evaporation process are increased, and the preparation efficiency of the evaporation process is affected.

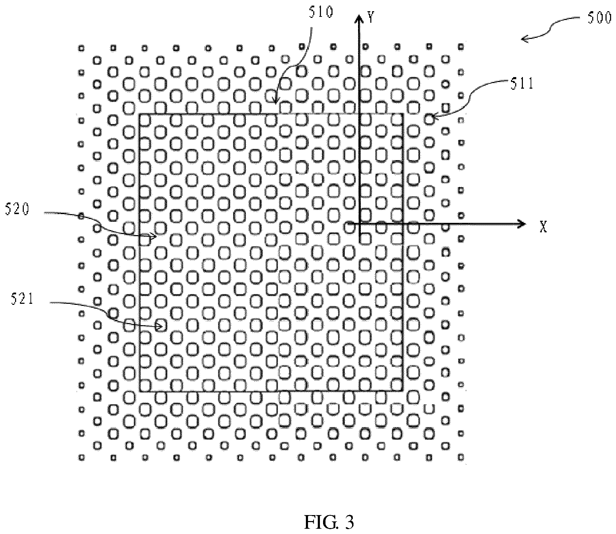

In order to increase the strength of the mask plate, the present application provides a mask plate with a special structure. The mask plate according to the present application has high strength, thereby improving the precision of pixel evaporation and avoiding the problem of uneven color development at the edge of the display panel. FIG. 3 is a schematic structural view of a mask plate according to an embodiment of the present application. As shown in FIG. 3, the mask plate 500 is configured to fabricate a display panel. The mask plate 500 includes a display region 520 and a transition display region 510. The display region 520 is configured to evaporate pixels to the main display region of the display panel, and the display region 520 is provided with a plurality of first through holes 521 disposed at intervals. The transition display region 510 is provided at a periphery of the display region 520, and the transition display region 510 is provided with a plurality of second through holes 511 arranged at intervals. The transition display region 510 is used for transition between the display region 520 and the edge of the mask plate 500. The density of the second through holes 511 is smaller than the density of the first through holes 521. That is, the percentage of the region occupied by the second through holes 511 in the transition display region 510 of the mask plate 500 is smaller than the percentage of the region occupied by the first through holes 521 in the display region 520 of the mask plate 500.

It should be understood that, in the conventional solution, as shown in FIG. 2, the shape of the opening, the size of the opening, and the density of the openings of the display region 300 and the transition display region 200 are the same. Therefore, the edge of the mask plate 100 is easily damaged, resulting in a problem of uneven color development in the edge region of the display panel fabricated from the mask plate. Therefore, in the present application, the density of the second through holes 511 in the transition display region 510 is changed, and the density of the second through holes 511 in the transition display region 510 is reduced. In this way, it is helpful to increase the distance between the second through holes 511, increase the area of the connecting bridge between the second through holes 511, and increase the strength of the edge region of the mask plate 500 without affecting the display effect.

In an embodiment, the geometric center of each of the first through holes 521 in the display region 520 is a first hole center. The geometric center of each of the second through holes 511 in the transition display region 510 is a second hole center. The arrangement of the first hole centers in the display region is the same as the arrangement of the second hole centers in the transition display region, and apertures of the second through holes 511 is smaller than apertures of the first through holes 521. Therefore, the distance between the outer edges of the adjacent second through holes 511 is greater than the distance between the outer edges of the adjacent first through holes 521.

The present application reduces the density of the second through holes 511 in the transition display region 510 by reducing the apertures of the second through holes 511 and increasing the distance between the outer edges of the adjacent second through holes 511. Thus, the area of the connecting bridge between the second through holes 511 is increased, and the strength of the edge of the mask plate 500 is increased.

In an embodiment, the first hole centers and the second hole centers are arranged in a row in a horizontal direction. The first hole centers and the second hole centers are arranged in a column in a vertical direction. The distances between the two adjacent first hole centers in the horizontal direction are equal, and the distances between the two adjacent first hole centers in the vertical direction are equal. The distances between the two adjacent second hole centers in the horizontal direction are equal, and the distances between the two adjacent first hole centers in the vertical direction are equal. The distance between the two adjacent first hole centers in the horizontal direction is equal to the distance between the two adjacent second hole centers in the horizontal direction. The distance between the two adjacent first hole centers in the vertical direction is equal to the distance between the two adjacent second hole centers in the vertical direction. That is, the first hole centers and the second hole centers are arranged in an array in the same manner, except that the apertures of the second through holes 511 in the transition display region 510 are reduced, and the distance between the adjacent second through holes 511 is increased, so that the density of the second through holes 511 in the transition display region 510 is decreased. The present application changes the structure of the mask plate 500 simply and conveniently, and further reduces the difficulty of the fabricating process of the mask plate 500, improves the strength of the mask plate 500, and helps to improve the stability of the net-extending process.

As shown in FIG. 3, in an embodiment, a direction extending away from the display region 520 in a horizontal direction is a first direction (X), and a direction extending away from the display region 520 in a vertical direction is a second direction (Y). The second through holes 511 are sequentially arranged as the first column of through holes, the second column of through holes to the M-th column of through holes in the first direction, and M is a positive integer. The first column of through holes is a column of the second through holes closest to the display region 520 in the first direction, and the M-th column of through holes is a column of the second through holes farthest from the display region 520 in the first direction. The second through holes 511 are sequentially arranged as the first row of through holes, the second row of through holes to the N-th row of through holes in the second direction, and N is a positive integer. The first row of through holes is a row of the second through holes closest to the display region 520 in the second direction, and the N-th row of through holes is a row of the second through holes farthest from the display region 520 in the second direction. The apertures of the N-th row of through holes and the M-th column of through holes are at least 0.3 times of the apertures of the first through holes 521 of the display region 520, so as to avoid the apertures of the second through holes 511 at the edge of the mask plate 500 being too small, which strongly affects the display effect of the edge region.

In an embodiment, apertures of the first row of through holes to the N-th row of through holes are reduced according to a first predetermined rule, and apertures of the first column of through holes to the N-th column of through holes are reduced according to a second predetermined rule. The first predetermined rule and the second predetermined rule may be the same or different. The first predetermined rule may be adjusted according to the number of rows of the second through holes. The second predetermined rule may be adjusted according to the number of columns of the second through holes. For example, the first predetermined rule is that the aperture decreases from the first row of through holes toward the N-th row of through holes, and the second predetermined rule is that the aperture decreases from the first column of through holes toward the M-th column of through holes.

In an embodiment, the number of rows and the number of columns of the second through holes in the transition region 510 may be the same.

In an embodiment, when two rows and two columns of the second through holes 511 are provided, the apertures of the first row of through holes and the first column of through holes are 0.6-0.9 times of the apertures of the first through holes 521. The apertures of the second row of through holes and the second column of through holes are 0.3-0.6 times of the apertures of the first through holes 521.

In an embodiment, when three rows and three columns of the second through holes 511 are provided, the apertures of the first row of through holes and the first column of through holes are 0.7-0.9 times of the apertures of the first through holes 521. The apertures of the second row of through holes and second column of through holes are 0.5-0.7 times of the apertures of the first through holes 521. The apertures of a third row of through holes and a third column of through holes are 0.3-0.5 times of the apertures of the first through holes 521.

In an embodiment, when four rows and four columns of the second through holes 511 are provided, the apertures of the first row of through holes and the first column of through holes are 0.8-0.9 times of the apertures of the first through holes 521. The apertures of the second row of through holes and the second column of through holes are 0.6-0.8 times of the apertures of the first through holes 521. The apertures of a third row of through holes and a third column of through holes are 0.4-0.6 times of the apertures of the first through holes 521. The apertures of a fourth row of through holes and a fourth column of through holes are 0.3-0.4 times of the apertures of the first through holes 521.

In an embodiment, when five rows and five columns of the second through holes 511 are provided, the apertures of the first row of the through holes and the first column of through holes are 0.8-0.9 times of the apertures of the first through holes 521. The apertures of the second row of through holes and the second column of through holes are 0.7-0.8 times of the apertures of the first through holes 521. The apertures of a third row of through holes and a third column of through holes are 0.6-0.7 times of the apertures of the first through holes 521. The apertures of a fourth row of through holes and a fourth column of through holes are 0.4-0.6 times of the apertures of the first through holes 521. The apertures of a fifth row of through holes and a fifth column of through holes are 0.3-0.4 times of the apertures of the first through holes 521.

In the present application, the number of rows and the number of columns of the second through holes in the transition display region 510 may be different. In the case where the number of rows and the number of columns are different, the variation rule of the apertures of the second through holes 511 is also different. Through providing an optimum gradation rule with the apertures of the second through holes 511 having different number of rows and columns, an optimum transition for the display effect of the transition display region 510 may be achieved.

In an embodiment, the number of rows of the second through holes 511 may not be equal to the number of columns of the second through holes 511. That is, the number of rows and the number of columns of the second through holes 511 in the transition display region 510 may be different. When a different number of rows or columns are provided, the variation rule of the apertures of the second through holes 511 may refer to the above solution. For example, the transition display region 510 may be arranged in three rows and four columns. The second through holes 511 in three rows may be disposed such that the apertures of the first row of through holes are 0.7-0.9 times of the apertures of the first through holes 521. The apertures of the second row of through holes are 0.5-0.7 times of the apertures of the first through holes 521. The apertures of a third row of through holes are 0.3-0.5 times of the apertures of the first through holes 521. The second through holes 511 in four columns may be disposed such that the apertures of the first column of through holes are 0.8-0.9 times of the apertures of the first through holes 521. The apertures of the second column of through holes are 0.6-0.8 times of the apertures of the first through holes 521. The apertures of a third column of through holes are 0.4-0.6 times of the apertures of the first through holes 521. The apertures of a fourth column of through holes are 0.3-0.4 times of the apertures of the first through holes 521.

The present application also provides a display panel. The display panel includes a display substrate and pixels arranged in an array on the display substrate. The pixels are fabricated from the mask plate as described above. The display panel has high resolution and high precision of pixel evaporation, and the problem of uneven display at the edge of the display panel can be avoided.

According to the mask plate 500 of the present application, the design margin may be increased in the horizontal direction and the vertical direction. The result of PPA (pixel position accuracy) testing of the mask plate of the present application is superior to that of the conventional solution. The strength of the mask plate 100 is improved, and the problem of uneven color development at the edge of the display panel is also reduced significantly.

The technical features of the above-mentioned embodiments may be combined in any combination. For the sake of brevity of description, all possible combinations of the technical features in the above embodiments are not described. However, the respective technical features mentioned in the same embodiment can also be combined arbitrarily as long as they have no collision with each other.

The above-described embodiments are merely illustrative of several embodiments of the present application, and the description thereof is more specific and detailed, but is not to be construed as limiting the scope of the invention. It should be noted that a number of variations and modifications may be made by those skilled in the art without departing from the spirit and scope of the present application. Therefore, the scope of protection of this application should be determined by the appended claims.

## Claims

1. A mask plate for making a display panel, comprising:
a display region provided with a plurality of first through holes arranged at intervals; and
a transition display region disposed at a periphery of the display region, and provided with a plurality of second through holes arranged at intervals,
a density of the second through holes being smaller than a density of the first through holes.

2. The mask plate according to claim 1, wherein:
a geometric center of each of the first through holes is a first hole center, and a geometric center of the second through holes is a second hole center;
the arrangement of the first hole centers in the display region is same to the arrangement of the second hole centers in the transition display region; and
apertures of the second through holes are smaller than apertures of the first through holes.

3. The mask plate according to claim 2, wherein:
the first hole centers and the second hole centers are arranged in a row in a horizontal direction, and the first hole centers and the second hole centers are arranged in a column in a vertical direction;
distances between two adjacent first hole centers in the horizontal direction are equal, and distances between two adjacent first hole centers in the vertical direction are equal; and
distances between two adjacent second hole centers in the horizontal direction are equal, and distances between two adjacent first hole centers in the vertical direction are equal.

4. The mask plate according to claim 3, wherein a distance between the two adjacent first hole centers in the horizontal direction is equal to a distance between the two adjacent second hole centers in the horizontal direction; and a distance between the two adjacent first hole centers in the vertical direction is equal to a distance between the two adjacent second hole centers in the vertical direction.

5. The mask plate according to claim 4, wherein:
a row of the second through holes closest to the display region is a first row of through holes of the transition display region, with sequentially a second row to an N-th row of through holes of the transition display region provided along a direction away from the display region, and N being a positive integer;
a column of the second through holes closest to the display region is a first column of through holes of the transition display region, with sequentially a second column to an M-th column of through holes of the transition display region provided along a direction away from the display region, and M being a positive integer; and
apertures of the N-th row of through holes and the M-th column of through holes are at least 0.3 times of the apertures of the first through holes.

6. The mask plate according to claim 5, wherein apertures of the first row of through holes to the N-th row of through holes are reduced according to a first predetermined rule, and apertures of the first column of through holes to the M-th column of through holes are reduced according to a second predetermined rule.

7. The mask plate according to claim 6, wherein the number of rows and the number of columns of the second through holes are the same.

8. The mask plate according to claim 7, wherein
when two rows and two columns of the second through holes are provided,
the apertures of the first row of through holes and the first column of through holes are 0.6-0.9 times of the apertures of the first through holes; and
the apertures of the second row of through holes and the second column of through holes are 0.3-0.6 times of the apertures of the first through holes.

9. The mask plate according to claim 7, wherein
when three rows and three columns of the second through holes are provided,
the apertures of the first row of through holes and the first column of through holes are 0.7-0.9 times of the apertures of the first through holes;
the apertures of the second row of through holes and the second column of through holes are 0.5-0.7 times of the apertures of the first through holes; and
apertures of a third row of through holes and a third column of through holes are 0.3-0.5 times of the apertures of the first through holes.

10. The mask plate according to claim 7, wherein
when four rows and four columns of the second through holes are provided,
the apertures of the first row of through holes and the first column of through holes are 0.8-0.9 times of the apertures of the first through holes;
the apertures of the second row of through holes and the second column of through holes are 0.6-0.8 times of the apertures of the first through holes;
apertures of a third row of through holes and a third column of through holes are 0.4-0.6 times of the apertures of the first through holes; and
apertures of a fourth row of through holes and a fourth column of through holes are 0.3-0.4 times of the apertures of the first through holes.

11. The mask plate according to claim 7, wherein
when five rows and five columns of the second through holes are provided,
the apertures of the first row of through holes and the first column of through holes are 0.8-0.9 times of the apertures of the first through holes;
the apertures of the second row of through holes and the second column of through holes are 0.7-0.8 times of the apertures of the first through holes;
apertures of a third row of through holes and a third column of through holes are 0.6-0.7 times of the apertures of the first through holes;
apertures of a fourth row of through holes and a fourth column of through holes are 0.4-0.6 times of the apertures of the first through holes; and
apertures of a fifth row of through holes and a fifth column of through holes are 0.3-0.4 times of the apertures of the first through holes.

12. The mask plate according to claim 6, wherein the number of rows and the number of columns of the second through holes are different.

13. The mask plate according to claim 12, wherein
when three rows and four columns of the second through holes are provided,
the apertures of the first row of through holes are 0.7-0.9 times of the apertures of the first through hole; the apertures of the second row of through holes are 0.5-0.7 times of the apertures of the first through hole; apertures of a third row of through holes are 0.3-0.5 times of the apertures of the first through holes; and
the apertures of the first column of through holes are 0.8-0.9 times of the apertures of the first through holes; the apertures of the second column of through holes are 0.6-0.8 times of the apertures of the first through holes; apertures of a third column of through holes are 0.4-0.6 times of the apertures of the first through holes; and apertures of a fourth column of through holes are 0.3-0.4 times of the apertures of the first through holes.

14. A display panel, comprising:
a display substrate; and
pixels arranged in an array on the display substrate;
wherein the pixels are fabricated from the mask plate of any one of claims 1-13.
